# EUROPEAN PATENT APPLICATION

(11) **EP 2 793 017 A1**
(43) Date of publication of application: **22.10.2014**
(21) Application number: 14164655.4
(22) Date of filing: 14.04.2014
(51) Int. Cl.: G01N 21/63, G01N 21/71, G01N 25/72, G01J 3/10

(54) **Optical non-destructive inspection apparatus and optical non-destructive inspection method**

(30) Priority: 18.04.2013 JP 2013087121
(71) Applicant: JTEKT CORPORATION, Osaka-shi Osaka 542-8502 (JP)
(72) Inventor: Matsumoto, Naoki, Osaka-shi, Osaka 542-8502 (JP); Yoshida, Kouya, Osaka-shi, Osaka 542-8502 (JP); Matsumoto, Jun, Osaka-shi, Osaka 542-8502 (JP)
(74) Representative: Winter, Brandl, Fürniss, Hübner, Röss, Kaiser, Polte - Partnerschaft mbB

(57) **Abstract**

There are provided an optical non-destructive inspection apparatus that can inspect a measurement object such as a wire bonding portion in a broad measurable temperature range in a short time, with high reliability, and an optical non-destructive inspection method using it. The apparatus includes a focusing-collimating unit (10), a heating laser beam source (21), a heating laser beam guide unit, a first infrared detector (35), a second infrared detector (31), an emitted-infrared selective guide unit, and a control unit (50). The control unit (50) controls the heating laser beam source (21), measures a temperature rise characteristic that is a temperature rise state of a measurement spot (SP) based on a heating time, on the basis of a ratio between a detected value from the first infrared detector (35) and a detected value from the second infrared detector (31), determines a state of a measurement object (a bonding structure (97)) based on the temperature rise characteristic, and changes at least one of wavelengths of infrared light beams guided to the first infrared detector (35) and the second infrared detector (31) based on a measured temperature during measurement.

## Description

### BACKGROUND OF THE INVENTION

### 1. Field of the Invention

The present invention relates to an optical non-destructive inspection apparatus and an optical non-destructive inspection method.

### 2. Description of Related Art

When an electrode is bonded to a semiconductor chip by wire bonding, the electrode and a wire can be bonded using various methods and it is necessary to inspect whether the electrode and the wire are appropriately bonded to each other. Conventionally, an operator visually inspects a bonding part while the bonding part is enlarged with a microscope or the like, or extracts a predetermined sample, destroys an electrode and a wire to inspect strength thereof or the like. When the bonding part is inspected visually by an operator, reliability of inspection results is low and inspection efficiency is low, because there may be difference in a skill level among operators, or the skill level of one operator may vary due to fatigue, a physical condition, or the like. When destructive inspection is performed on an extracted sample, it is not possible to assure that all the other objects that are not samples and are not actually destroyed (all the other objects that are not extracted) are in the same state as the state of the destroyed sample.

Therefore, in a conventional technology described in Japanese Patent Application Publication No. 2011-191232 (JP 2011-191232 A), a method and an apparatus are described, which determine whether the state of wire bonding is appropriate in a non-contact manner on the basis of an area of a bonding part. In the technology, a target position of a wire is heated with a laser beam, a small amount of an infrared light beam emitted from the heated position is measured by using a two-wavelength infrared emission thermometer, a temperature variation up to a saturated temperature is measured, a numerical value correlated with an area of a bonding part is determined on the basis of the temperature variation, and it is determined whether the bonding state is appropriate on the basis of the numerical value. In the technology, a ratio between infrared light beams with two different wavelengths is used to measure a temperature rise state until the temperature reaches a saturated temperature due to heating, and actually, measurement accuracy and a measurable temperature range are determined depending on what wavelengths are selected as two wavelengths.

In a technology described in Japanese Patent Application Publication No. 2008-145344 (JP 2008-145344 A), a small metal bonding part evaluation method is described, in which a bonding part is heated up to a predetermined temperature with a laser beam, a temperature falling state after stoppage of irradiation with a laser beam is measured by using a temperature-measuring infrared sensor, and it is determined whether a bonding state is appropriate on the basis of the temperature falling state. Further, a reflectance-measuring laser beam and a reflectance-measuring infrared sensor are provided, and reflectance is measured to correct the measured temperature falling state. In the technology, the result of irradiation with a reflectance-measuring laser beam is detected by using the reflectance-measuring infrared sensor. That is, in order to measure the reflectance, an object is heated with the reflectance-measuring laser beam. Thus, the object is heated with the reflectance-measuring laser beam in addition to being heated with the original heating laser beam. Accordingly, the temperature fall characteristic as the measurement result is influenced by the change in the temperature due to the reflectance-measuring laser beam. Thus, it is doubtful whether appropriate correction is performed. The time until the temperature reaches the saturated temperature during heating is generally several tens of ms, but the temperature falling time after heating is generally several tens of seconds to several minutes. Accordingly, in the technology in which the temperature falling time is measured, the inspection time is extremely long, which is not preferable.

In another conventional technology described in Japanese Patent No. 4857422, a thermophysical property measuring method and a thermophysical property measuring apparatus are described, in which a sample is fused and floated in a high-frequency coil in a vacuum chamber, a fundamental equation of heat conduction that appropriately represents a method of measuring a thermophysical property value using laser heating is derived, and actual thermophysical property of a conductive material fused at a high temperature can be directly measured. This technology is a method in which a sample is fused and floated by using a large-scaled apparatus and cannot be applied to inspection of the state of wire bonding.

### SUMMARY OF THE INVENTION

The present invention is made in view of the above, and an object of the present invention is to provide an optical non-destructive inspection apparatus and an optical non-destructive inspection method, in which a measurement object such as a wire bonding portion can be inspected in a broader measurable temperature range in a shorter time, with higher reliability and higher measurement accuracy. An aspect of the present invention relates to an optical non-destructive inspection apparatus.

The optical non-destructive inspection apparatus includes a focusing-collimating unit that emits parallel light, which is incident from a first side along an optical axis, from a second side, focuses the parallel light to a measurement spot set on a measurement object as a focal position, converts light, which is emitted and reflected from the measurement spot and incident from the second side, into parallel light along the optical axis, and emits the parallel light from the first side; a heating laser beam source that emits a heating laser beam for heating the measurement object without destroying the measurement object; a heating laser beam guide unit that guides the heating laser beam to the first side of the focusing-collimating unit; a first infrared detector and a second infrared detector that detect infrared light beams emitted from the measurement spot; a control unit; and an emitted-infrared selective guide unit that guides infrared light beams with two different wavelengths, out of the parallel light emitted from the measurement spot and emitted from the first side of the focusing-collimating unit, to the first infrared detector and the second infrared detector, respectively, the infrared light beams with the two different wavelengths being selected by the control unit. The control unit receives a detection signal from the first infrared detector and a detection signal from the second infrared detector while controlling the heating laser beam source so as to heat the measurement spot with the heating laser beam, measures a temperature of the measurement spot based on a ratio between a detected value from the first infrared detector and a detected value from the second infrared detector, measures a temperature rise characteristic that is a temperature rise state of the measurement spot based on a heating time, determines a state of the measurement object based on the measured temperature rise characteristic, and controls the emitted-infrared selective guide unit based on the measured temperature during measurement so as to change at least one of the wavelengths of the infrared light beams guided to the first infrared detector and the second infrared detector.

In the above-mentioned aspect, since the temperature rise characteristic of the measurement object is measured during heating, the inspection can be performed in a shorter time. Further, the infrared light beams with two appropriate wavelengths are selected based on measurement accuracy and a measurable temperature range, and the infrared light beams are detected by the first infrared detector and the second infrared detector. Since the temperature of the measurement spot is measured based on the ratio between the detected values of the infrared light beams with the two wavelengths selected based on the measurement accuracy and the measurable temperature range, it is possible to measure the temperature in a broader temperature range with higher accuracy, as compared to a case where two wavelengths of the infrared light beams to be measured are fixed. In addition, it is possible to stably perform the inspection with higher reliability without an influence of the skill level, physical condition, or the like of an operator.

According to another aspect of the present invention, in the optical non-destructive inspection apparatus according to the above-mentioned aspect, the emitted-infrared selective guide unit may include a first emitted-infrared guide unit that guides one of an infrared light beam with a first infrared wavelength and an infrared light beam with a second infrared wavelength, out of the parallel light emitted from the measurement spot and emitted from the first side of the focusing-collimating unit, to the first infrared detector, the one of the infrared light beam with the first infrared wavelength and the infrared light beam with the second infrared wavelength being selected by the control unit; and a second emitted-infrared guide unit that guides an infrared light beam with a predetermined infrared wavelength out of the parallel light emitted from the measurement spot and emitted from the first side of the focusing-collimating unit, to the second infrared detector.

In the above-mentioned aspect, the infrared light beam guided to the first infrared detector is the infrared light beam that is selected out of the infrared light beam with the first infrared wavelength and the infrared light beam with the second infrared wavelength. The infrared light beam guided to the second infrared detector is the infrared light beam with the predetermined infrared wavelength. Thus, the emitted-infrared selective guide unit is specifically configured. Thus, with the simple configuration, it is possible to perform the inspection in a practical temperature range with practical accuracy.

According to a yet another aspect of the present invention, in the optical non-destructive inspection apparatus according to the above-mentioned aspect, the heating laser beam guide unit may include a heating laser beam collimating unit that is disposed in vicinity of the heating laser beam source, and converts the heating laser beam emitted from the heating laser beam source into parallel light; and a heating-laser selective reflection unit that is disposed on the optical axis of the focusing-collimating unit, reflects the heating laser beam to the first side of the focusing-collimating unit, and transmits a light beam with a wavelength different from a wavelength of the heating laser beam out of the parallel light emitted and reflected from the measurement spot and emitted from the first side of the focusing-collimating unit, or a heating-laser selective reflection unit that is disposed on the optical axis of the focusing-collimating unit, transmits the heating laser beam to the first side of the focusing-collimating unit, and reflects the light beam with the wavelength different from the wavelength of the heating laser beam out of the parallel light emitted and reflected from the measurement spot and emitted from the first side of the focusing-collimating unit.

In the above-mentioned aspect, it is possible to appropriately realize the heating laser beam guide unit.

According to another aspect of the present invention, in the optical non-destructive inspection apparatus according to the above-mentioned aspect, the first emitted-infrared guide unit may include the heating-laser selective reflection unit; a predetermined-infrared selective reflection unit disposed in a path of parallel light that is emitted from the first side of the focusing-collimating unit and transmitted or reflected by the heating-laser selective reflection unit and has a wavelength different from the wavelength of the heating laser beam, the predetermined-infrared selective reflection unit transmitting the infrared light beam with the predetermined infrared wavelength out of the parallel light to the second infrared detector, and reflecting the parallel light with a wavelength different from the predetermined infrared wavelength to the first infrared detector, or a predetermined-infrared selective reflection unit disposed in the path of the parallel light that is emitted from the first side of the focusing-collimating unit and transmitted or reflected by the heating-laser selective reflection unit and has the wavelength different from the wavelength of the heating laser beam, the predetermined-infrared selective reflection unit reflecting the infrared light beam with the predetermined infrared wavelength out of the parallel light to the second infrared detector, and transmitting the parallel light with the wavelength different from the predetermined infrared wavelength to the first infrared detector; a first infrared selective reflection unit that, when disposed in a path of parallel light reflected or transmitted in a direction different from a direction toward the second infrared detector by the predetermined-infrared selective reflection unit, transmits or reflects the infrared light beam with the first infrared wavelength out of the parallel light; a second infrared selective reflection unit that, when disposed in the path of the parallel light reflected or transmitted in the direction different from the direction toward the second infrared detector by the predetermined-infrared selective reflection unit, transmits or reflects the infrared light beam with the second infrared wavelength out of the parallel light; a position moving unit that allows a position of one of the first infrared selective reflection unit and the second infrared selective reflection unit to move onto the path of the parallel light reflected or transmitted in the direction different from the direction toward the second infrared detector by the predetermined-infrared selective reflection unit, the position moving unit being controlled by the control unit; and a first infrared focusing unit that is disposed in vicinity of the first infrared detector, and focuses the infrared light beam with the first infrared wavelength or the second infrared wavelength, which is reflected or transmitted by the first infrared selective reflection unit or the second infrared selective reflection unit, to the first infrared detector, the infrared light beam with the first infrared wavelength or the second infrared wavelength being parallel light.

In the above-mentioned aspect, it is possible to appropriately realize the first emitted-infrared guide unit.

According to a yet another aspect of the present invention, in the optical non-destructive inspection apparatus according to the above-mentioned aspect, the second emitted-infrared guide unit may include the heating-laser selective reflection unit; the predetermined-infrared selective reflection unit; and a second infrared focusing unit that is disposed in vicinity of the second infrared detector, and focuses the infrared light beam with the predetermined infrared wavelength, which is transmitted or reflected by the predetermined-infrared selective reflection unit, to the second infrared detector, the infrared light beam with the predetermined infrared wavelength being parallel light.

In the above-mentioned aspect, it is possible to appropriately realize the second emitted-infrared guide unit.

According to a yet another aspect of the present invention, in the optical non-destructive inspection apparatus according to any one of the above-mentioned aspects, the first infrared wavelength may be set to a wavelength longer than the predetermined infrared wavelength, and the second infrared wavelength may be set to a wavelength shorter than the predetermined infrared wavelength.

In the above-mentioned aspect, a relation between the first infrared wavelength and the second infrared wavelength is set so that the first infrared wavelength is longer than the predetermined infrared wavelength, and the second infrared wavelength is shorter than the predetermined infrared wavelength (the first infrared wavelength > the predetermined infrared wavelength > the second infrared wavelength). Thus, with the simple configuration, it is possible to realize the optical non-destructive inspection apparatus in which the temperature can be measured in a broader measurable temperature range with higher accuracy.

According to a yet another aspect of the present invention, in the optical non-destructive inspection apparatus according to the above-mentioned aspect, the control unit may control the position moving unit so that the infrared light beam with the first infrared wavelength transmitted or reflected by the first infrared selective reflection unit is guided to the first infrared detector when the temperature of the measurement spot is lower than a predetermined temperature during measurement, may control the position moving unit so that the infrared light beam with the second infrared wavelength transmitted or reflected by the second infrared selective reflection unit is guided to the first infrared detector when the temperature of the measurement spot is equal to or higher than the predetermined temperature during measurement, and may determine the state of the measurement object based on the temperature rise characteristic that is based on the measured temperature and the heating time.

In the above-mentioned aspect, the control unit controls the position moving unit based on the measured temperature. Thus, the infrared light beam with the first infrared wavelength or the second infrared wavelength can be appropriately guided to the first infrared detector.

According to a yet another aspect of the present invention, in the optical non-destructive inspection apparatus, the measurement object may be a bonding structure including a bonding part in which two members are bonded, the measurement spot may be set on a surface of one of the two members, and the control unit may determine a bonding state of the two members based on the temperature rise characteristic.

In the above-mentioned aspect, for example, when the two members are an electrode and a wire, the optical non-destructive inspection apparatus can be used to determine whether the bonding state of the electrode and the wire is appropriate.

According to a yet another aspect of the present invention, in the optical non-destructive inspection apparatus according to the above-mentioned aspect, the bonding state of the two members to be determined may be a magnitude of an area of the bonding part of the two members, and the control unit may determine whether the area of the bonding part of the two members is in an allowable range, based on the temperature rise characteristic.

In the above-mentioned aspect, for example, when the two members are an electrode and a wire, it is determined whether the area of the bonding part of the electrode and the wire is in the allowable range. Therefore, it is possible to more appropriately determine whether the bonding state of the electrode and the wire is appropriate.

A yet another aspect of the present invention relates to an optical non-destructive inspection method, wherein the optical non-destructive inspection apparatus according to any one of the above-mentioned aspects is used, and wherein the state of the measurement object, the bonding state of the two members, or whether an area of the bonding part of the two members is in an allowable range is determined by the control unit.

In the above-mentioned aspect, it is possible to provide the optical non-destructive inspection method, in which the measurement object such as a wire bonding portion can be inspected in a broader measurable temperature range in a shorter time, with higher reliability and higher measurement accuracy.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1A is a diagram illustrating an example of a measurement object;
FIG. 1B is a diagram illustrating an example of a state in which a wire is bonded to an electrode through wire bonding;
FIG. 2 is a diagram illustrating a configuration of an optical non-destructive inspection apparatus according to a first embodiment;
FIG. 3 is a diagram illustrating a configuration of an optical non-destructive inspection apparatus according to a second embodiment;
FIG. 4 is a diagram illustrating a configuration of an optical non-destructive inspection apparatus according to a third embodiment;
FIG. 5 is a diagram illustrating a configuration of an optical non-destructive inspection apparatus according to a fourth embodiment;
FIG. 6 is a flowchart illustrating an example of a procedure of processing performed by the optical non-destructive inspection apparatus;
FIG. 7 is a diagram illustrating examples of a first infrared selective reflection unit, a second infrared selective reflection unit, and a position moving unit for the first and second infrared selective reflection units;
FIG. 8 is a diagram illustrating a relationship among a wavelength of an infrared light beam, energy of the infrared light beam, and a temperature;
FIG. 9 is a diagram illustrating a relationship between a temperature and an energy ratio (two-wavelength ratio) between infrared light beams with two different wavelengths;
FIG. 10 is a diagram illustrating an example of a temperature rise characteristic that is measured and
FIG. 11 is a diagram illustrating a method of determining whether an area of a bonding part is in an allowable range, using the temperature rise characteristic.

### DETAILED DESCRIPTION OF EMBODIMENTS

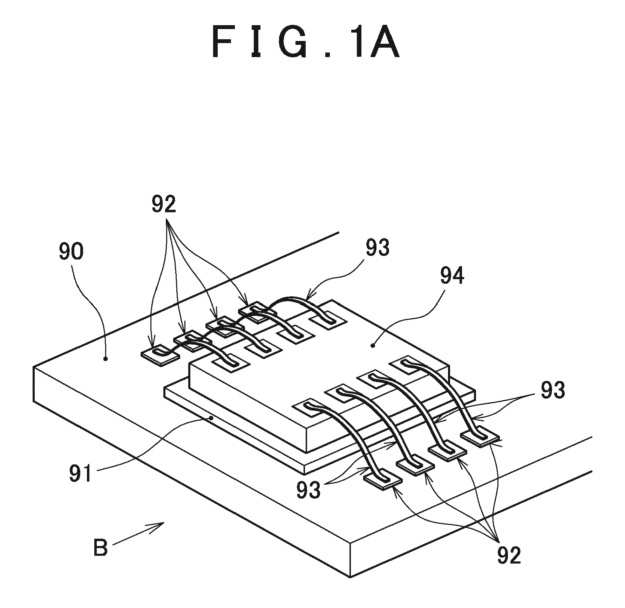

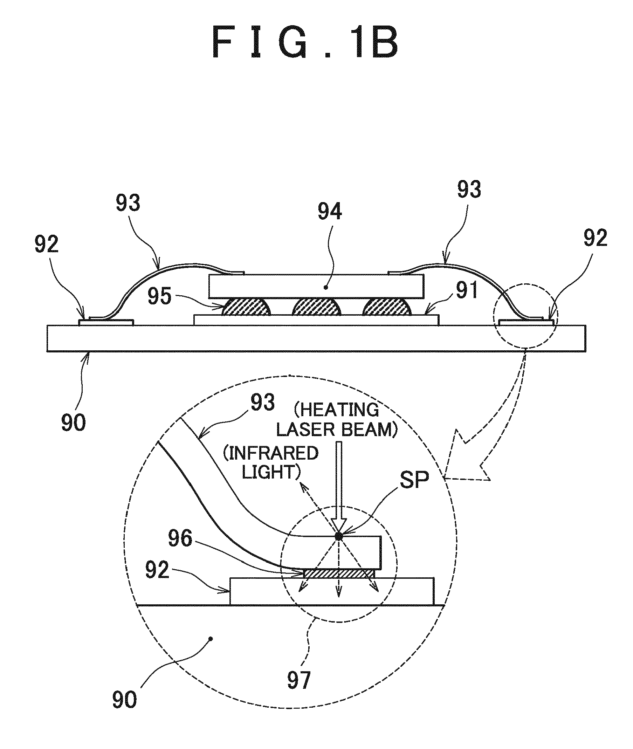

Hereinafter, embodiments of the present invention will be described with reference to the accompanying drawings. A measurement object will be described with reference to FIGS. 1A and 1B. FIG. 1A is a perspective view of a board 90. A first end of a wire 93 that is formed of aluminum or the like and that has a diameter of several tens of µm to several hundreds of µm is mechanically and electrically bonded to each electrode 92 disposed on the board 90 through wire bonding, and a second end of the wire 93 is bonded to each terminal of a semiconductor chip 94 fixed onto the board 90. FIG. 1B is a view of FIG. 1A when viewed in a direction B. In this embodiment, a bonding structure 97 including a bonding part 96 in which the wire 93 and the electrode 92 are bonded to each other is described as a measurement object.

In order to determine whether the wire 93 is appropriately bonded to the electrode 92, it may be determined whether a bonding state is appropriate based on whether the area of the bonding part 96, that is, the area of a region, in which the surface of the wire 93 and the surface of the electrode 92 are parallel to each other in FIG. 1B, is in an allowable range. Therefore, as illustrated in the enlarged view of the bonding structure 97 in FIG. 1B, a measurement spot SP is set on the surface of the wire 93 of the bonding structure 97 and the measurement spot SP is irradiated and heated with a heating laser beam. Then, the temperature of the measurement spot SP gradually rises and heat transfers from the measurement spot SP to the electrode 92 via the inner portion of the wire 93 and the bonding part 96. An infrared light beam corresponding to the raised temperature is emitted from the bonding structure 97 including the measurement spot SP.

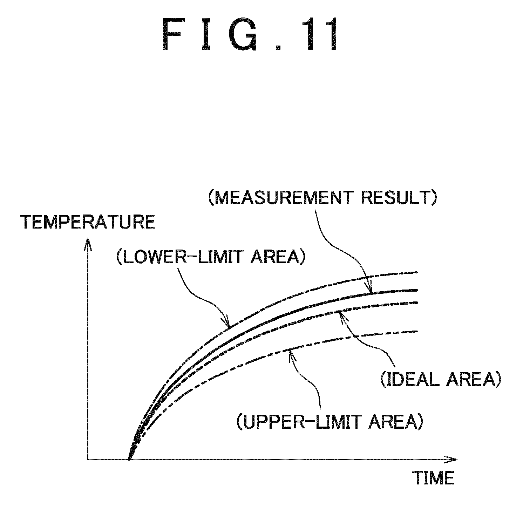

The temperature of the measurement spot SP gradually rises, and when the temperature reaches a saturated temperature at which the quantity of heat added and the quantity of heat dissipated are equal to each other, the rise in temperature stops and then, the temperature becomes substantially constant in spite of continuous heating. When the area of the bonding part 96 is large, the quantity of heat transferring to the electrode 92 is large, and therefore, the temperature rises relatively gradually with the lapse of a heating time, and the saturated temperature is lowered. When the area of the bonding part 96 is small, the quantity of heat transferring to the electrode 92 is small, and therefore, the temperature rises relatively sharply with the lapse of the heating time, and the saturated temperature is raised (see FIG. 11). Thus, it is possible to determine whether the bonding state is appropriate by irradiating the measurement spot SP with a heating laser beam, measuring the temperature rise characteristic illustrated in FIG. 11, determining the area of the bonding part 96 on the basis of the temperature rise characteristic, and determining whether the area of the bonding part 96 is in an allowable range. Hereinafter, details of an optical non-destructive inspection apparatus and an optical non-destructive inspection method that can determine whether the bonding state is appropriate will be described.

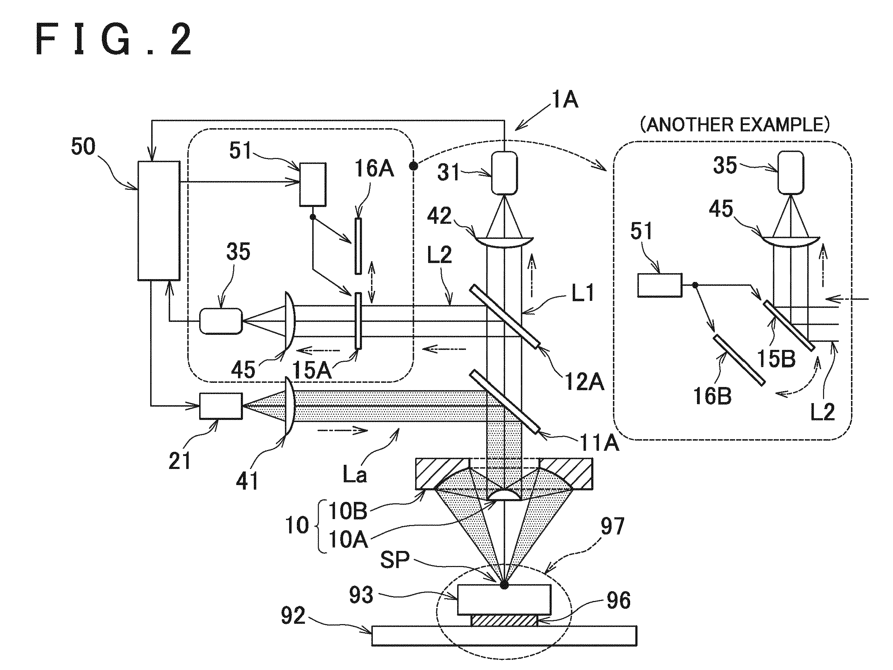

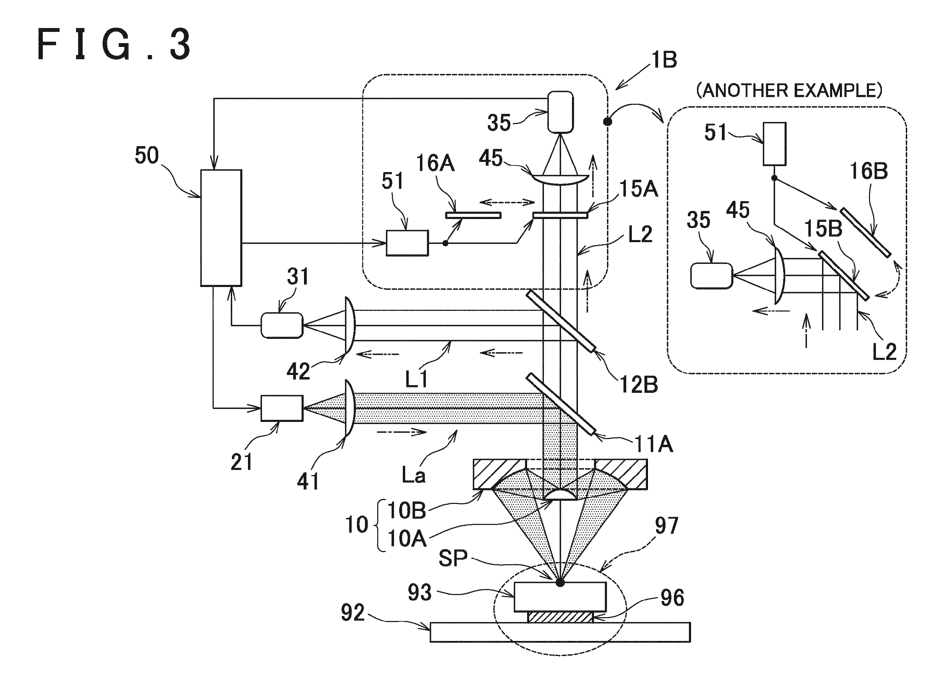

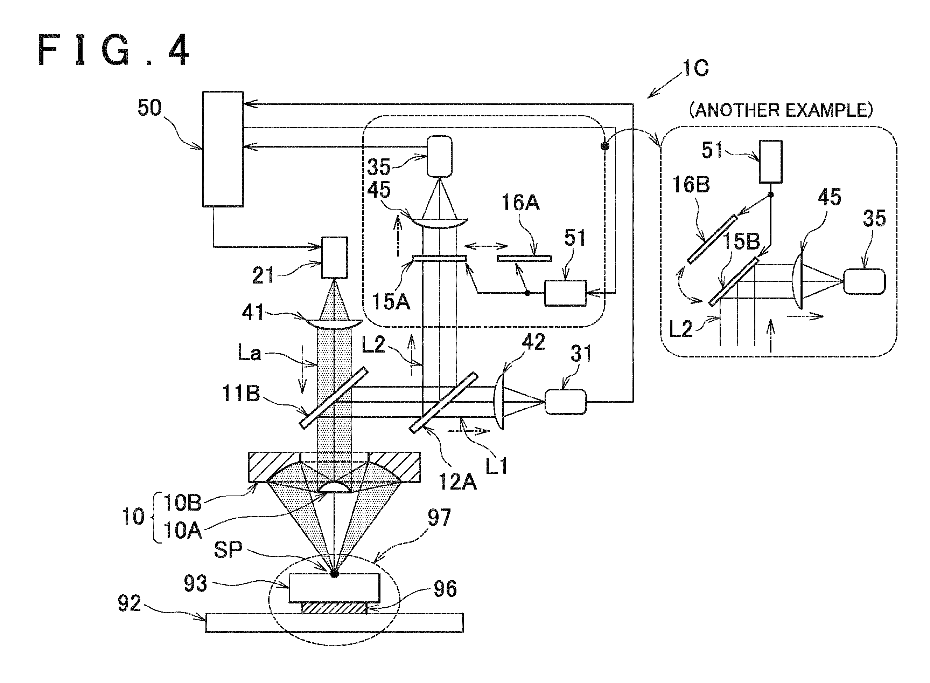

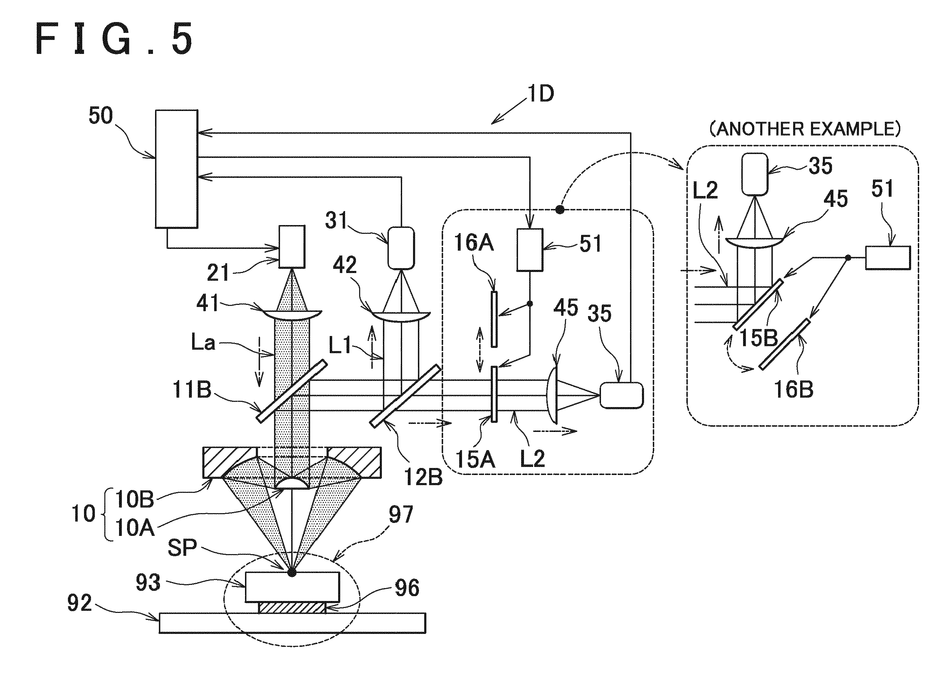

FIG. 2 illustrates the configuration of a first embodiment, FIG. 3 illustrates the configuration of a second embodiment, FIG. 4 illustrates the configuration of a third embodiment, and FIG. 5 illustrates the configuration of a fourth embodiment. In the first to fourth embodiments, elements are the same but arrangement positions or directions (reflection direction or transmission direction) or the like are different.

First, the configuration of an optical non-destructive inspection apparatus 1A according to the first embodiment will be described below. The optical non-destructive inspection apparatus 1A illustrated in FIG. 2 includes a focusing-collimating unit 10, a heating-laser selective reflection unit 11A, a predetermined-infrared selective reflection unit 12A, a first infrared selective reflection unit 15A, a second infrared selective reflection unit 16A, a position moving unit 51, a heating laser beam source 21, a first infrared detector 35, a second infrared detector 31, a heating laser beam collimating unit 41, a first infrared focusing unit 45, a second infrared focusing unit 42, and a control unit 50.

The focusing-collimating unit 10 emits parallel light, which is incident from a first side (the upper side in FIG. 2) along its own optical axis, from a second side (the lower side in FIG. 2) and focuses the parallel light to the measurement spot SP set on the measurement object as a focal position. The focusing-collimating unit 10 converts light emitted and reflected from the measurement spot SP and incident from the second side, into parallel light along the optical axis and emits the parallel light from the first side. The focusing-collimating unit 10 may be formed by using a focusing lens that transmits and refracts light. However, since light beams with plural different wavelengths are treated, a focusing lens causing chromatic aberration is not preferable. Therefore, by forming the focusing-collimating unit 10 using aspheric reflecting mirrors 10A and 10B, occurrence of chromatic aberration is prevented to cope with a broad wavelength band.

The heating laser beam source 21 emits a heating laser beam, whose output level is adjusted so that the heating laser beam heats the measurement object without destroying the measurement object, on the basis of a control signal from the control unit 50. The wavelength of the heating laser beam is referred to as a heating laser wavelength λa. The heating laser beam source 21 is, for example, a semiconductor laser.

The heating laser beam collimating unit 41 is disposed in the vicinity of the heating laser beam source 21, that is, in the vicinity of a laser beam emission position at a position on the optical axis of the heating laser beam, and converts the heating laser beam emitted from the heating laser beam source 21 into a heating laser beam La that is parallel light. For example, the heating laser beam collimating unit 41 needs to convert only a light beam with the heating laser wavelength λa into parallel light and thus may be a collimation lens. When the heating laser beam source 21 can emit parallel light, the heating laser beam collimating unit 41 may be omitted.

The heating-laser selective reflection unit 11A is disposed on the optical axis of the focusing-collimating unit 10 and reflects the heating laser beam La, which is obtained by converting the heating laser beam emitted from the heating laser beam source 21 into parallel light, to the first side of the focusing-collimating unit 10. The wavelength of the heating laser beam La is the heating laser wavelength λa. The heating-laser selective reflection unit 11A transmits the light beam with a wavelength different from the heating laser wavelength λa out of the parallel light emitted and reflected from the measurement spot SP and emitted from the first side of the focusing-collimating unit 10. For example, the heating-laser selective reflection unit 11A is a dichroic mirror that reflects the light beam with the heating laser wavelength λa and transmits the light beam with a wavelength other than the heating laser wavelength λa. A heating laser beam guide unit is constituted by the heating laser beam collimating unit 41 and the heating-laser selective reflection unit 11A, and the heating laser beam guide unit converts the heating laser beam emitted from the heating laser beam source 21 into parallel light and guides the parallel light to the first side of the focusing-collimating unit 10.

Each of the first infrared detector 35 and the second infrared detector 31 can detect energy of an infrared light beam emitted from the measurement spot SP. For example, the first infrared detector 35 and the second infrared detector 31 are infrared sensors. The detection signals from the first infrared detector 35 and the second infrared detector 31 are acquired by the control unit 50.

A predetermined-infrared selective reflection unit 12A is disposed in the path of the parallel light emitted from the first side of the focusing-collimating unit 10 and transmitted by the heating-laser selective reflection unit 11A, and is disposed on the optical axis of the focusing-collimating unit 10 in this embodiment. The parallel light is parallel light having a wavelength different from the heating laser wavelength λa. The predetermined-infrared selective reflection unit 12A transmits parallel light L1 that is an infrared light beam with a predetermined infrared wavelength λ1 out of the parallel light emitted from the focusing-collimating unit 10 and transmitted by the heating-laser selective reflection unit 11A, to the second infrared detector 31, and reflects parallel light L2 with a wavelength different from the predetermined infrared wavelength λ1. Therefore, the second infrared detector 31 detects only energy of the infrared light beam with the predetermined infrared wavelength λ1. For example, the predetermined-infrared selective reflection unit 12A is a dichroic mirror that transmits the light beam with the predetermined infrared wavelength λ1 and that reflects the light beam with a wavelength other than the predetermined infrared wavelength λ1.

The second infrared focusing unit 42 is disposed in the vicinity of the second infrared detector 31 and focuses the infrared light beam as the parallel light with the predetermined infrared wavelength λ1 transmitted by the predetermined-infrared selective reflection unit 12A, to the detection position of the second infrared detector 31. For example, since the second infrared focusing unit 42 needs to focus only the light beam with the predetermined infrared wavelength λ1, the second infrared focusing unit 42 may be a focusing lens. A second emitted-infrared guide unit is constituted by the heating-laser selective reflection unit 11A, the predetermined-infrared selective reflection unit 12A, and the second infrared focusing unit 42. The second emitted-infrared guide unit extracts the infrared light beam with the predetermined infrared wavelength λ1 out of the parallel light emitted from the measurement spot SP and emitted from the first side of the focusing-collimating unit 10 and guides the extracted infrared light beam to the second infrared detector 31.

One of a first infrared selective reflection unit 15A and a second infrared selective reflection unit 16A is disposed in the path of the parallel light L2 reflected by the predetermined-infrared selective reflection unit 12A in a direction different from a direction toward the second infrared detector 31, that is, in the direction toward the first infrared detector 35. The wavelength of the parallel light L2 is a wavelength other than the predetermined infrared wavelength λ1.

The control unit 50 can arrange one of the first infrared selective reflection unit 15A and the second infrared selective reflection unit 16A in the path of the parallel light L2 by controlling the position moving unit 51. The first infrared selective reflection unit 15A is a filter or a dichroic mirror that transmits an infrared light beam with a first infrared wavelength λ11 for low temperature measurement out of the parallel light L2. The second infrared selective reflection unit 16A is a filter or a dichroic mirror that transmits an infrared light beam with a second infrared wavelength λ12 for high temperature measurement out of the parallel light L2. The position moving unit 51 can move one of the first infrared selective reflection unit 15A and the second infrared selective reflection unit 16A in the path of the parallel light L2 on the basis of the control signal from the control unit 50.

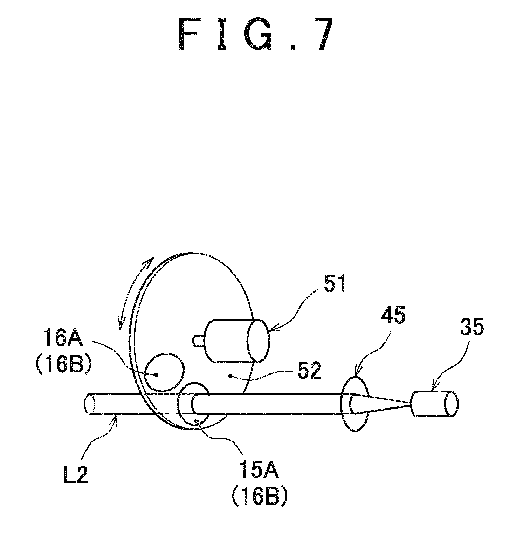

FIG. 7 illustrates an example of structures of the position moving unit 51, the first infrared selective reflection unit 15A, and the second infrared selective reflection unit 16A. The position moving unit 51 is an electric motor and can rotate a disc-shaped support 52 in an arbitrary direction on the basis of the control signal from the control unit 50. In the support 52, the first infrared selective reflection unit 15A (or 15B) and the second infrared selective reflection unit 16A (or 16B) are fitted to hollow portions. The control unit 50 can change the position of the first infrared selective reflection unit 15A (or 15B) and the position of the second infrared selective reflection unit 16A (or 16B) by controlling the position moving unit 51 so as to rotationally drive the support 52.

The first infrared focusing unit 45 is disposed in the vicinity of the first infrared detector 35 and focuses the infrared light beam as parallel light with the first infrared wavelength λ11 or the second infrared wavelength λ12, which is transmitted by the first infrared selective reflection unit 15A or the second infrared selective reflection unit 16A, to the detection position of the first infrared detector 35. For example, the first infrared focusing unit 45 may be a focusing lens. A first emitted-infrared guide unit is constituted by the heating-laser selective reflection unit 11A, the predetermined-infrared selective reflection unit 12A, the first infrared selective reflection unit 15A, the second infrared selective reflection unit 16A, the position moving unit 51, and the first infrared focusing unit 45. The first emitted-infrared guide unit extracts the infrared light beam with the first infrared wavelength λ11 or the second infrared wavelength λ12 out of the parallel light emitted from the measurement spot SP and emitted from the first side of the focusing-collimating unit 10, and guides the extracted infrared light beam to the first infrared detector 35.

The area surrounded by a dotted line in FIG. 2 may be replaced with the configuration described as "another example". That is, the first infrared selective reflection unit 15A may be replaced with a first infrared selective reflection unit 15B that reflects the infrared light beam with the first infrared wavelength λ11, and the second infrared selective reflection unit 16A may be replaced with a second infrared selective reflection unit 16B that reflects the infrared light beam with the second infrared wavelength λ12. As each of the first infrared selective reflection unit 15B and the second infrared selective reflection unit 16B, a dichroic mirror or the like is employed. In this case, the first infrared focusing unit 45 and the first infrared detector 35 are disposed at the destination of the reflected parallel light with the first infrared wavelength λ11 or the second infrared wavelength λ12 out of the parallel light L2.

The control unit 50 is, for example, a personal computer, receives a detection signal from the first infrared detector 35 and a detection signal from the second infrared detector 31 and measures the temperature of the measurement spot SP on the basis of a ratio between the detected value from the first infrared detector 35 and the detected value from the second infrared detector 31, while controlling the heating laser beam source 21 so as to heat the measurement spot SP with the heating laser beam. The control unit 50 measures a temperature rise characteristic that is a temperature rise state of the measurement spot based on the heating time and determines the state of the measurement object on the basis of the measured temperature rise characteristic. During measurement, the control unit 50 controls the position moving unit 51, that is, the first emitted-infrared guide unit, so as to change the selected infrared wavelength (the first infrared wavelength λ11 or the second infrared wavelength λ12) based on the measured temperature. The detailed operation of the control unit 50 will be described later.

The configuration of an optical non-destructive inspection apparatus 1B according to the second embodiment will be described below with reference to FIG. 3. Differences from the optical non-destructive inspection apparatus 1A according to the first embodiment will be mainly described. The optical non-destructive inspection apparatus 1B according to the second embodiment is different from the optical non-destructive inspection apparatus 1A according to the first embodiment, in the operation of a predetermined-infrared selective reflection unit 12B and the arrangements of the first infrared detector 35, the second infrared detector 31, and the like.

The predetermined-infrared selective reflection unit 12B is the same as the predetermined-infrared selective reflection unit 12A, in that the predetermined-infrared selective reflection unit 12B is disposed in the path of the parallel light emitted from the first side of the focusing-collimating unit 10 and transmitted by the heating-laser selective reflection unit 11A and is disposed on the optical axis of the focusing-collimating unit 10. However, the predetermined-infrared selective reflection unit 12B is different from the predetermined-infrared selective reflection unit 12A, in that the predetermined-infrared selective reflection unit 12B reflects (the predetermined-infrared selective reflection unit 12A transmits) the parallel light L1 as the infrared light beam with the predetermined infrared wavelength λ1 out of the parallel light emitted from the first side of the focusing-collimating unit 10 and transmitted by the heating-laser selective reflection unit 11A, to the second infrared detector 31 and transmits (the predetermined-infrared selective reflection unit 12A reflects) the parallel light L2 with a wavelength different from the predetermined infrared wavelength λ1. The predetermined-infrared selective reflection unit 12B is, for example, a dichroic mirror that reflects the light beam with the predetermined infrared wavelength λ1 and transmits the light beam with a wavelength other than the predetermined infrared wavelength λ1.

Accordingly, the second infrared focusing unit 42 and the second infrared detector 31 are disposed at the reflection destination of the predetermined-infrared selective reflection unit 12B. The first infrared selective reflection unit 15A, the second infrared selective reflection unit 16A, the position moving unit 51, the first infrared focusing unit 45, and the first infrared detector 35 are disposed at the transmission destination of the predetermined-infrared selective reflection unit 12B.

The area surrounded by a dotted line in FIG. 3 may be replaced with the configuration described as "another example". That is, the first infrared selective reflection unit 15A may be replaced with the first infrared selective reflection unit 15B that reflects the infrared light beam with the first infrared wavelength λ11, and the second infrared selective reflection unit 16A may be replaced with the second infrared selective reflection unit 16B that reflects the infrared light beam with the second infrared wavelength λ12. As each of the first infrared selective reflection unit 15B and the second infrared selective reflection unit 16B, a dichroic mirror or the like is employed. In this case, the first infrared focusing unit 45 and the first infrared detector 35 are disposed at the destination of the reflected parallel light with the first infrared wavelength λ11 or the second infrared wavelength λ12 out of the parallel light L2.

The configuration of an optical non-destructive inspection apparatus 1C according to the third embodiment will be described below with reference to FIG. 4. Differences from the optical non-destructive inspection apparatus 1A according to the first embodiment will be mainly described. The optical non-destructive inspection apparatus 1C according to the third embodiment is different from the optical non-destructive inspection apparatus 1A according to the first embodiment, in the operation of a heating-laser selective reflection unit 11B and the arrangement of the heating laser beam source 21.

The heating-laser selective reflection unit 11B is disposed on the optical axis of the focusing-collimating unit 10 and transmits (the heating-laser selective reflection unit 11A reflects) the heating laser beam La with the heating laser wavelength λa, which is obtained by converting the heating laser beam emitted from the heating laser beam source 21 into parallel light, to the first side of the focusing-collimating unit 10. In addition, the heating-laser selective reflection unit 11B reflects (the heating-laser selective reflection unit 11A transmits) parallel light with a wavelength different from the heating laser wavelength λa that is emitted and reflected from the measurement spot SP and emitted from the first side of the focusing-collimating unit 10. For example, the heating-laser selective reflection unit 11B is a dichroic mirror that transmits the light beam with the heating laser wavelength λa and reflects the light beam with a wavelength other than the heating laser wavelength λa. The destination of the parallel light with a wavelength other than the heating laser wavelength λa reflected by the heating-laser selective reflection unit 11B is the same as that in the first embodiment and will not be repeatedly described.

The area surrounded by a dotted line in FIG. 4 may be replaced with the configuration described as "another example". That is, the first infrared selective reflection unit 15A may be replaced with the first infrared selective reflection unit 15B that reflects the infrared light beam with the first infrared wavelength λ11, and the second infrared selective reflection unit 16A may be replaced with the second infrared selective reflection unit 16B that reflects the infrared light beam with the second infrared wavelength λ12. As each of the first infrared selective reflection unit 15B and the second infrared selective reflection unit 16B, a dichroic mirror or the like is employed. In this case, the first infrared focusing unit 45 and the first infrared detector 35 are disposed at the destination of the reflected parallel light with the first infrared wavelength λ11 or the second infrared wavelength λ12 out of the parallel light L2.

The configuration of an optical non-destructive inspection apparatus 1D according to the fourth embodiment will be described below with reference to FIG. 5. Differences from the optical non-destructive inspection apparatus 1B according to the second embodiment will be mainly described. The optical non-destructive inspection apparatus 1D according to the fourth embodiment is different from the optical non-destructive inspection apparatus 1B according to the second embodiment, in the operation of a heating-laser selective reflection unit 11B and the arrangement of the heating laser beam source 21 or the like.

As is the case with the third embodiment, the heating-laser selective reflection unit 11B is disposed on the optical axis of the focusing-collimating unit 10 and transmits (the heating-laser selective reflection unit 11A reflects) the heating laser beam La with the heating laser wavelength λa, which is obtained by converting the heating laser beam emitted from the heating laser beam source 21 into parallel light, to the first side of the focusing-collimating unit 10. In addition, the heating-laser selective reflection unit 11B reflects (the heating-laser selective reflection unit 11A transmits) parallel light with a wavelength different from the heating laser wavelength λa, which is emitted and reflected from the measurement spot SP and emitted from the first side of the focusing-collimating unit 10. For example, the heating-laser selective reflection unit 11B is a dichroic mirror that transmits the light beam with the heating laser wavelength λa and reflects the light beam with a wavelength other than the heating laser wavelength λa. The destination of the parallel light with a wavelength other than the heating laser wavelength λa reflected by the heating-laser selective reflection unit 11B is the same as that in the second embodiment and will not be repeatedly described.

The area surrounded by a dotted line in FIG. 5 may be replaced with the configuration described as "another example". That is, the first infrared selective reflection unit 15A may be replaced with the first infrared selective reflection unit 15B (a dichroic mirror or the like) that reflects the infrared light beam with the first infrared wavelength λ11, and the second infrared selective reflection unit 16A may be replaced with the second infrared selective reflection unit 16B (a dichroic mirror or the like) that reflects the infrared light beam with the second infrared wavelength λ12. As each of the first infrared selective reflection unit 15B and the second infrared selective reflection unit 16B, a dichroic mirror or the like is employed. In this case, the first infrared focusing unit 45 and the first infrared detector 35 are disposed at the destination of the reflected parallel light with the first infrared wavelength λ11 or the second infrared wavelength λ12 out of the parallel light L2.

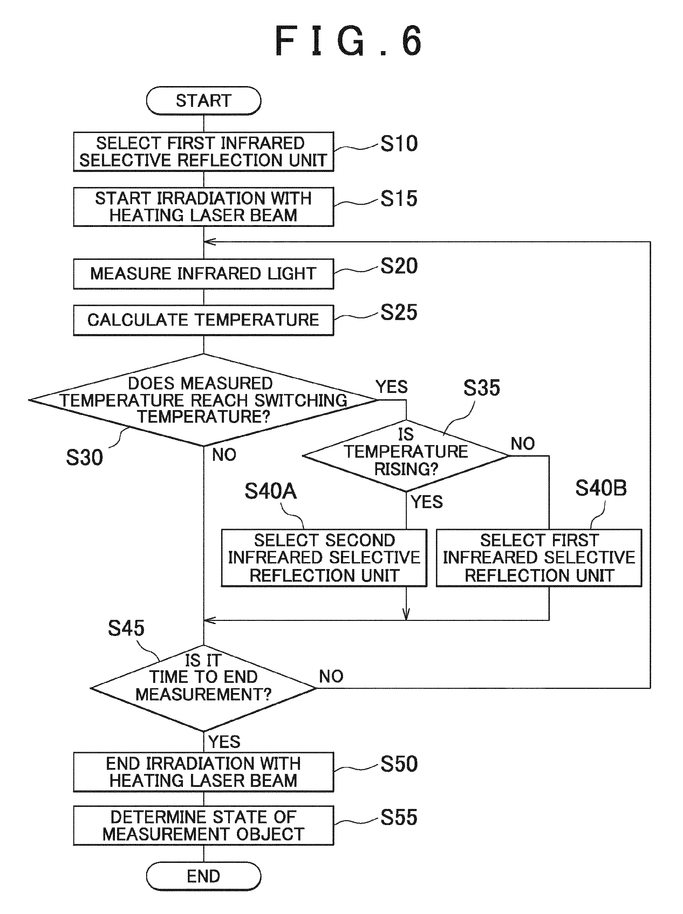

The procedure of (first) processing performed by the control unit 50 will be described below with reference to the flowchart illustrated in FIG. 6. Here, the configuration of the optical non-destructive inspection apparatus may be the configuration in any one of the first to fourth embodiments. The processing illustrated in FIG. 6 is performed by the control unit 50 when the measurement spot is inspected.

In step S10, the control unit 50 controls the position moving unit so as to dispose the first infrared selective reflection unit 15A for low temperature measurement in the path of the parallel light L2, and then performs the process of step S15. In step S15, the control unit 50 controls the heating laser beam source so that a heating laser beam is emitted from the heating laser beam source, and then performs the process of step S20. The heating laser beam is guided to the measurement spot and the infrared light beam emitted from the measurement spot is guided to the first infrared detector and the second infrared detector.

In step S20, the control unit 50 receives the detected value of energy of an infrared light beam with a selected infrared wavelength (the first infrared wavelength λ11 in this case) based on the detection signal from the first infrared detector, the detected value of energy of the infrared light beam with the predetermined infrared wavelength λ1 based on the detection signal from the second infrared detector, and the time after irradiation with the heating laser beam is started in step S15, and then performs the process of step S25.

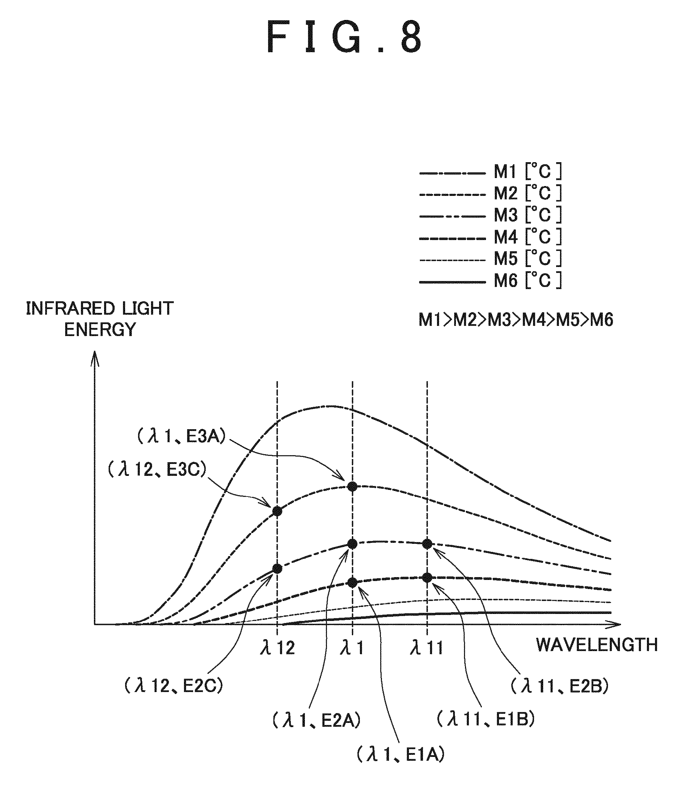

In step S25, the control unit 50 determines the temperature of the measurement spot on the basis of the ratio between the detected value from the first infrared detector and the detected value from the second infrared detector, and then performs the process of step S30. For example, FIG. 8 illustrates an example of an infrared emission characteristic representing the relationship between the wavelength of the infrared light beam radiated from a black body (indicated by the horizontal axis) and energy of the infrared light beam with the corresponding wavelength (indicated by the vertical axis) when the temperature of the black body completely absorbing and radiating irradiated light is each of temperatures (M1, M2, M3, M4, M5, and M6). For example, it is assumed that the measurement spot is a block body, the position of the detected predetermined infrared wavelength λ1 is the position of λ1 illustrated in FIG. 8, the position of the detected first infrared wavelength λ11 is the position of λ11 illustrated in FIG. 8, and the position of the detected second infrared wavelength λ12 is the position of λ12 illustrated in FIG. 8.

When the value of energy of the infrared light beam with the first infrared wavelength λ11 detected by the first infrared detector is E1B and the value of energy of the infrared light beam with the predetermined infrared wavelength λ1 detected by the second infrared detector is E1A, the control unit 50 determines the temperature of the measurement spot using the ratio of the detected value E1A to the detected value E1B (E1A / E1B) and an E(λ1) / E (λ11) characteristic diagram in the temperature-two-wavelength ratio characteristic diagram. In this case, the control unit 50 determines that the temperature is M4 (°C). E1A / E1B is the two-wavelength ratio, which represents a ratio between values of energy of infrared light beams with two different wavelengths.

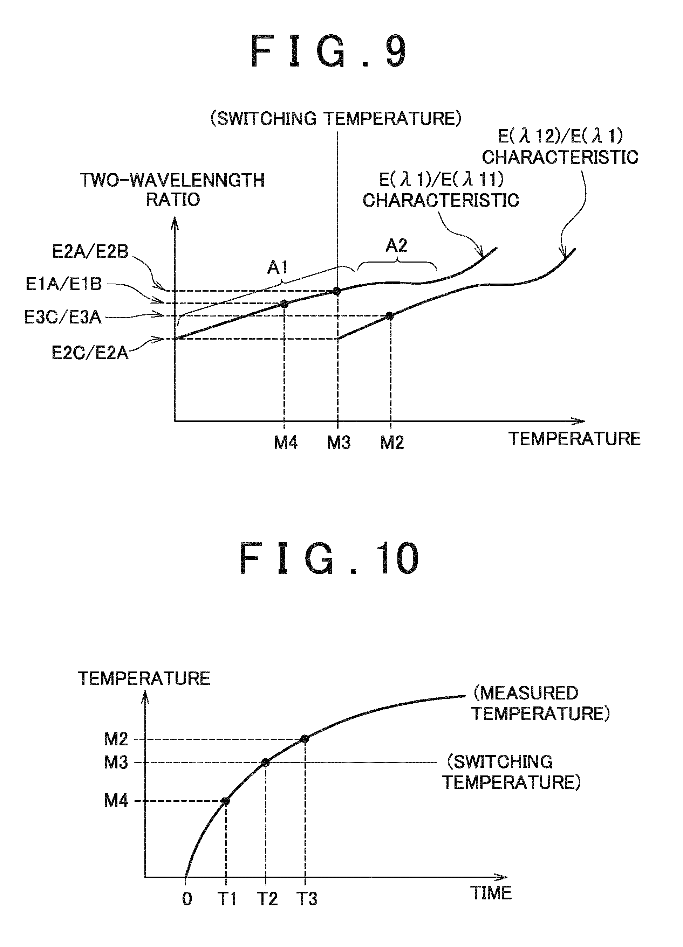

In the temperature-two-wavelength ratio characteristic diagram illustrated in FIG. 9, the horizontal axis indicates the temperature and the vertical axis indicates the two-wavelength ratio. The E(λ1) / E(λ11) characteristic diagram has an appropriate inclination in a low-temperature area A1 at the initial time of heating and thus the temperature corresponding to the two-wavelength ratio can be appropriately determined. However, as the temperature rises, the inclination becomes gradual in a high-temperature area A2 and it is thus difficult to determine the accurate temperature corresponding to the two-wavelength ratio. However, since the characteristic diagram is switched to the E(λ12) / E(λ1) characteristic diagram at a switching temperature before the temperature enters the high-temperature area A2 in which the inclination is gradual, it is possible to detect the temperature in a broader temperature range with higher accuracy.

The temperature-two-wavelength ratio characteristic diagram illustrated in the example of FIG. 9 is stored in a storage unit in advance. By using the ratio between the detected values of infrared light energy, the control unit 50 can determine the accurate temperature of the measurement spot without being influenced by the reflectance (emissivity) of the measurement spot. Then, the control unit 50 determines the temperature rise characteristic illustrated in the example in FIG. 10, on the basis of the elapsed time from the start of irradiation (corresponding to the heating time) and the temperature corresponding to the time. In FIG. 10, for example, the elapsed time from the start of irradiation is T1 and the measured temperature (temperature calculated from the measured energy of the infrared light beams) is M4 (°C).

In step S30, the control unit 50 determines whether the measured temperature reaches the switching temperature at which the wavelength should be switched from the first infrared wavelength λ11 to the second infrared wavelength λ12. The process of step S35 is performed when it is determined that the measured temperature reaches the switching temperature (the measured temperature is equal to or higher than the switching temperature) (YES), and the process of step S45 is performed when it is determined that the measured temperature does not reach the switching temperature (NO). The switching temperature is set to an appropriate value depending on the materials of the wire 93 and the electrode 92 in the bonding structure 97, the output of the heating laser beam, and the like.

In step S35, the control unit 50 compares the previously-measured temperature and the currently-measured temperature and determines whether the temperature is rising. The process of step S40A is performed when it is determined that the temperature is rising (YES), and the process of step S40B is performed when it is determined that the temperature is not rising (NO).

In step S40A, the control unit 50 controls the position moving unit so as to arrange the second infrared selective reflection unit in the path of the parallel light L2 and then performs the process of step S45. In step S40B, the control unit 50 controls the position moving unit so as to arrange the first infrared selective reflection unit in the path of the parallel light L2 and then performs the process of step S45. The time required for arranging the first infrared selective reflection unit or arranging the second infrared selective reflection unit is extremely short (for example, less than 1 ms) and is a time short enough not to affect the measurement of the temperature rise characteristic.

In step S45, the control unit 50 determines whether it is time to end the measurement. The control unit 50 determines that it is time to end the measurement when it is determined that the measured temperature reaches a saturated temperature. For example, when a temperature rising value, by which the temperature currently measured in step S25 is higher than the temperature previously measured in step S25, is equal to or less than a predetermined value, the control unit 50 determines that the measured temperature reaches the saturated temperature. The saturated temperature is a temperature when the inclination of the temperature rise characteristic illustrated in FIG. 10 is equal to or less than a predetermined value. After the temperature reaches the saturated temperature, the temperature is almost constant.

The control unit 50 performs the process of step S50 when it is determined that the measured temperature reaches the saturated temperature and it is time to end the measurement (YES), and performs the process of step S20 again when it is determined that it is not time to end the measurement (NO). When the processing returns to step S20 after a predetermined time (for example, about 1 ms) passes, the temperature can be measured at predetermined time intervals, which is preferable. When the processing returns to step S20 after the second infrared selective reflection unit is arranged in the path of the parallel light L2 in step S40A, the first infrared detector detects the energy of the infrared light beam with the second infrared wavelength λ12.

For example, the temperature rise characteristic illustrated in FIG. 10 shows an example where the switching temperature is set to M3 (°C), the detected value of energy of the infrared light beam with the first infrared wavelength λ11 at time T1 is E1B in FIG. 8, and the detected value of energy of the infrared light beam with the predetermined infrared wavelength λ1 is E1A. At this time, the temperature determined based on the two-wavelength ratio (E1A / E1B) and the temperature-two-wavelength ratio characteristic (FIG. 9) is M4 (°C). At time T2, the detected value of energy of the infrared light beam with the first infrared wavelength λ11 is E2B, the detected value of energy of the infrared light beam with the predetermined infrared wavelength λ1 is E2A, and the temperature determined based on the two-wavelength ratio (E2A / E2B) and the temperature-two-wavelength ratio characteristic (FIG. 9) is M3 (°C). Since the measured temperature reaches the switching temperature M3 (°C), the control unit 50 switches the infrared selective reflection unit from the first infrared selective reflection unit to the second infrared selective reflection unit after the temperature is measured. At time T3, the detected value of energy of the infrared light beam with the second infrared wavelength λ12 is E3C, the detected value of energy of the infrared light beam with the predetermined infrared wavelength λ1 is E3A, and the temperature determined based on the two-wavelength ratio (E3C / E3A) and the temperature-two-wavelength ratio characteristic (FIG. 9) is M2 (°C).

In step S50, the control unit 50 controls the heating laser beam source so as to stop the irradiation with the heating laser beam, and then performs the process of step S55. In step S55, the control unit 50 determines the state of the measurement object, that is, the area of the bonding part, on the basis of the temperature rise characteristic that is based on the temperature determined in step S25 and the heating time, displays the determination result on a display device or the like, and then finishes the processing.

FIG. 11 illustrates an example of the temperature rise characteristic (indicated by a dotted line in FIG. 11) when the area of the bonding part 96 in FIG. 1 is equal to an ideal area, an example of the temperature rise characteristic (indicated by an alternate long and short dash line in FIG. 11) when the area of the bonding part 96 is equal to a lower-limit area, and an example of the temperature rise characteristic (indicated by an alternate long and two short dashes line in FIG. 11) when the area of the bonding part 96 is equal to an upper-limit area. For example, the lower-limit-area temperature rise characteristic when the area of the bonding part 96 is equal to the lower-limit area and the upper-limit area temperature rise characteristic when the area of the bonding part 96 is equal to the upper-limit area are stored in the storage unit.

In step S55, the control unit 50 determines whether the temperature rise characteristic, which is history of the measured temperature of the bonding structure and the heating time, lies between the lower-limit-area temperature rise characteristic and the upper-limit area temperature rise characteristic stored in the storage unit. When the temperature rise characteristic of the measurement object lies between the lower-limit-area temperature rise characteristic and the upper-limit area temperature rise characteristic, it is determined that the bonding state is appropriate. When the temperature rise characteristic does not lie between the lower-limit-area temperature rise characteristic and the upper-limit area temperature rise characteristic, it is determined that the bonding state is inappropriate. The control unit 50 displays the determination result. When the measured temperature rise characteristic of the bonding structure lies between the lower-limit-area temperature rise characteristic and the upper-limit area temperature rise characteristic, the area of the bonding part is between the lower-limit area and the upper-limit area, that is, the area of the bonding part is in an allowable range.

A method in which the processing illustrated in FIG. 6 is performed by using the above-mentioned optical non-destructive inspection apparatus according to each of the first to fourth embodiments may be used as an optical non-destructive inspection method for determining the state of the bonding structure 97 as a measurement object or the bonding state of two members (the wire 93 and the electrode 92) or determining whether the area of the bonding part of two members (the wire 93 and the electrode 92) is in an allowable range.

Since the optical non-destructive inspection apparatus described in each of the above-mentioned embodiments determines the state of the measurement object using the temperature rise characteristic in a period of several tens of ms until the temperature reaches the saturated temperature after the heating is started with the heating laser beam, the inspection time is extremely short as compared to the case (several tens of seconds to several minutes) in which the state is determined using the heat-dissipation state after heating. Since the temperature is measured while two wavelengths to be detected are switched between two wavelengths for low temperature measurement (the predetermined infrared wavelength λ1 and the first infrared wavelength λ11) and two wavelengths for high temperature measurement (the second infrared wavelength λ12 and the predetermined infrared wavelength λ1), the measurable temperature range is broader and the measurement accuracy can be further improved, as compared to the case where the ratio between infrared light beams with two fixed different wavelengths is used. Each of the above-mentioned embodiments can be used to determine whether the bonding state of a wire-bonding part or the like is appropriate. Thus, it is possible to perform inspection with higher reliability, as compared to an operator's visual inspection or destructive inspection of an extracted sample.

Various modifications, additions, or deletions may be made to the optical non-destructive inspection apparatus, the optical non-destructive inspection method, and the configuration, structure, appearance, shape, processing procedure and the like of the inspection apparatus, without departing from the scope of the present invention. The infrared emission characteristic (FIG. 8) described in the embodiments and the selection of the predetermined infrared wavelength λ1, the first infrared wavelength λ11, and the second infrared wavelength λ12 indicated in the infrared emission characteristics are only examples and the present invention is not limited to the examples.

In the embodiments, only the predetermined infrared wavelength λ1 is used as the wavelength of the infrared light beam guided to the second infrared detector and one selected out of two wavelengths, which are the first infrared wavelength λ11 and the second infrared wavelength λ12, is used as the wavelength of the infrared light beam guided to the first infrared detector. However, the wavelength of the infrared light beam guided to the second infrared detector may be selected out of plural wavelengths by the control unit and the wavelength of the infrared light beam guided to the first infrared detector may be selected out of plural wavelengths by the control unit. Thus, at least one of the wavelengths of the infrared light beams guided to the first infrared detector and the second infrared detector needs to be selectively changed by the control unit. Instead of selecting one from two wavelengths, three or more selective reflection units (selective reflection units corresponding to the wavelengths) may be disposed in the support 52 illustrated in FIG. 7 and one may be selected out of three or more wavelengths.

## Claims

1. An optical non-destructive inspection apparatus comprising:
a focusing-collimating unit that emits parallel light, which is incident from a first side along an optical axis, from a second side, focuses the parallel light to a measurement spot set on a measurement object as a focal position, converts light, which is emitted and reflected from the measurement spot and incident from the second side, into parallel light along the optical axis, and emits the parallel light from the first side;
a heating laser beam source that emits a heating laser beam for heating the measurement object without destroying the measurement object;
a heating laser beam guide unit that guides the heating laser beam to the first side of the focusing-collimating unit;
a first infrared detector and a second infrared detector that detect infrared light beams emitted from the measurement spot;
a control unit; and
an emitted-infrared selective guide unit that guides infrared light beams with two different wavelengths, out of the parallel light emitted from the measurement spot and emitted from the first side of the focusing-collimating unit, to the first infrared detector and the second infrared detector, respectively, the infrared light beams with the two different wavelengths being selected by the control unit,
wherein the control unit
receives a detection signal from the first infrared detector and a detection signal from the second infrared detector while controlling the heating laser beam source so as to heat the measurement spot with the heating laser beam,
measures a temperature of the measurement spot based on a ratio between a detected value from the first infrared detector and a detected value from the second infrared detector,
measures a temperature rise characteristic that is a temperature rise state of the measurement spot based on a heating time,
determines a state of the measurement object based on the measured temperature rise characteristic, and
controls the emitted-infrared selective guide unit based on the measured temperature during measurement so as to change at least one of the wavelengths of the infrared light beams guided to the first infrared detector and the second infrared detector.

2. The optical non-destructive inspection apparatus according to claim 1, wherein
the emitted-infrared selective guide unit includes:
a first emitted-infrared guide unit that guides one of an infrared light beam with a first infrared wavelength and an infrared light beam with a second infrared wavelength, out of the parallel light emitted from the measurement spot and emitted from the first side of the focusing-collimating unit, to the first infrared detector, the one of the infrared light beam with the first infrared wavelength and the infrared light beam with the second infrared wavelength being selected by the control unit; and
a second emitted-infrared guide unit that guides an infrared light beam with a predetermined infrared wavelength out of the parallel light emitted from the measurement spot and emitted from the first side of the focusing-collimating unit, to the second infrared detector.

3. The optical non-destructive inspection apparatus according to claim 2, wherein
the heating laser beam guide unit includes:
a heating laser beam collimating unit that is disposed in vicinity of the heating laser beam source, and converts the heating laser beam emitted from the heating laser beam source into parallel light; and
a heating-laser selective reflection unit that is disposed on the optical axis of the focusing-collimating unit, reflects the heating laser beam to the first side of the focusing-collimating unit, and transmits a light beam with a wavelength different from a wavelength of the heating laser beam out of the parallel light emitted and reflected from the measurement spot and emitted from the first side of the focusing-collimating unit, or
a heating-laser selective reflection unit that is disposed on the optical axis of the focusing-collimating unit, transmits the heating laser beam to the first side of the focusing-collimating unit, and reflects the light beam with the wavelength different from the wavelength of the heating laser beam out of the parallel light emitted and reflected from the measurement spot and emitted from the first side of the focusing-collimating unit.

4. The optical non-destructive inspection apparatus according to claim 3, wherein
the first emitted-infrared guide unit includes:
the heating-laser selective reflection unit;
a predetermined-infrared selective reflection unit disposed in a path of parallel light that is emitted from the first side of the focusing-collimating unit and transmitted or reflected by the heating-laser selective reflection unit and has a wavelength different from the wavelength of the heating laser beam, the predetermined-infrared selective reflection unit transmitting the infrared light beam with the predetermined infrared wavelength out of the parallel light to the second infrared detector, and reflecting the parallel light with a wavelength different from the predetermined infrared wavelength to the first infrared detector, or
a predetermined-infrared selective reflection unit disposed in the path of the parallel light that is emitted from the first side of the focusing-collimating unit and transmitted or reflected by the heating-laser selective reflection unit and has the wavelength different from the wavelength of the heating laser beam, the predetermined-infrared selective reflection unit reflecting the infrared light beam with the predetermined infrared wavelength out of the parallel light to the second infrared detector, and transmitting the parallel light with the wavelength different from the predetermined infrared wavelength to the first infrared detector;
a first infrared selective reflection unit that, when disposed in a path of parallel light reflected or transmitted in a direction different from a direction toward the second infrared detector by the predetermined-infrared selective reflection unit, transmits or reflects the infrared light beam with the first infrared wavelength out of the parallel light;
a second infrared selective reflection unit that, when disposed in the path of the parallel light reflected or transmitted in the direction different from the direction toward the second infrared detector by the predetermined-infrared selective reflection unit, transmits or reflects the infrared light beam with the second infrared wavelength out of the parallel light;
a position moving unit that allows a position of one of the first infrared selective reflection unit and the second infrared selective reflection unit to move onto the path of the parallel light reflected or transmitted in the direction different from the direction toward the second infrared detector by the predetermined-infrared selective reflection unit, the position moving unit being controlled by the control unit; and
a first infrared focusing unit that is disposed in vicinity of the first infrared detector, and focuses the infrared light beam with the first infrared wavelength or the second infrared wavelength, which is reflected or transmitted by the first infrared selective reflection unit or the second infrared selective reflection unit, to the first infrared detector, the infrared light beam with the first infrared wavelength or the second infrared wavelength being parallel light.

5. The optical non-destructive inspection apparatus according to claim 4, wherein
the second emitted-infrared guide unit includes:
the heating-laser selective reflection unit;
the predetermined-infrared selective reflection unit; and
a second infrared focusing unit that is disposed in vicinity of the second infrared detector, and focuses the infrared light beam with the predetermined infrared wavelength, which is transmitted or reflected by the predetermined-infrared selective reflection unit, to the second infrared detector, the infrared light beam with the predetermined infrared wavelength being parallel light.

6. The optical non-destructive inspection apparatus according to claim 4 or 5,
wherein
the control unit
controls the position moving unit so that the infrared light beam with the first infrared wavelength transmitted or reflected by the first infrared selective reflection unit is guided to the first infrared detector when the temperature of the measurement spot is lower than a predetermined temperature during measurement,
controls the position moving unit so that the infrared light beam with the second infrared wavelength transmitted or reflected by the second infrared selective reflection unit is guided to the first infrared detector when the temperature of the measurement spot is equal to or higher than the predetermined temperature during measurement, and
determines the state of the measurement object based on the temperature rise characteristic that is based on the measured temperature and the heating time.

7. The optical non-destructive inspection apparatus according to any one of claims 2 to 6,
wherein the first infrared wavelength is set to a wavelength longer than the predetermined infrared wavelength, and
wherein the second infrared wavelength is set to a wavelength shorter than the predetermined infrared wavelength.

8. The optical non-destructive inspection apparatus according to any one of claims 1 to 7,
wherein the measurement object is a bonding structure including a bonding part in which two members are bonded,
wherein the measurement spot is set on a surface of one of the two members, and wherein the control unit determines a bonding state of the two members based on the temperature rise characteristic.

9. The optical non-destructive inspection apparatus according to claim 8,
wherein the bonding state of the two members to be determined is a magnitude of an area of the bonding part of the two members, and
wherein the control unit determines whether the area of the bonding part of the two members is in an allowable range, based on the temperature rise characteristic.

10. An optical non-destructive inspection method,
wherein the optical non-destructive inspection apparatus according to any one of claims 1 to 7 is used, and
wherein the state of the measurement object is determined by the control unit.

11. An optical non-destructive inspection method,
wherein the optical non-destructive inspection apparatus according to claim 8 is used, and
wherein the bonding state of the two members is determined by the control unit.

12. An optical non-destructive inspection method,
wherein the optical non-destructive inspection apparatus according to claim 9 is used, and
wherein whether the area of the bonding part of the two members is in an allowable range is determined by the control unit.
